# EUROPÄISCHE PATENTSCHRIFT

(11) **EP 0 959 539 B1**
(45) Veröffentlichungstag und Bekanntmachung des Hinweises auf die Patenterteilung: **03.01.2007**
(21) Anmeldenummer: 99105333.1
(22) Anmeldetag: 16.03.1999
(51) Int. Cl.: H01S 5/0683

(54) **Schaltungsanordnung zur Regelung der Ausgangsleistung einer Laserdiode**
Circuit for controlling the power output of a laser diode
Circuit de commande de puissance de sortie d'une diode laser

(30) Priorität: 22.05.1998 DE 19822920
(43) Veröffentlichungstag der Anmeldung: 24.11.1999
(73) Patentinhaber: Marconi Communications GmbH, 71522 Backnang (DE)
(72) Erfinder: Kremers, Ernst, 71540 Murrhardt (DE); Thiel, Helmut, 73547 Lorch (DE); Kunst, Johannes, 71522 Backnang (DE)
(74) Vertreter: Manitz, Finsterwald & Partner GbR

(56) Entgegenhaltungen:
- JP-A- 4 142 127
- JP-A- 4 152 582
- JP-A- 6 061 555
- US-A- 5 335 239

## Beschreibung

Die Erfindung betrifft eine Schaltungsanordnung zur Regelung der Ausgangsleistung einer Laserdiode mit einer Vorstromschaltung sowie einer Modulationsschaltung mit dem im Oberbegriff des Anspruchs 1 genannten Merkmalen.

### Stand der Technik

Aus der JP-A-6 061 555 ist eine Schaltungsanordnung nach dem Oberbegriff des Anspruchs 1 bekannt. Eine Schaltungsanordnung zur Regelung der Ausgangsleistung einer Laserdiode ist aus der JP A-4 142 127 bekannt.

Schaltungsanordnungen der gattungsgemäßen Art sind bekannt. Diese dienen dazu, die Ausgangsleistung und somit die optische Sendeleistung einer Laserdiode zu regeln. Laserdioden werden beispielsweise in der optischen Nachrichtentechnik eingesetzt, um optische Signale in eine Übertragungsstrecke, beispielsweise einem Lichtwellenleiter, einzuspeisen. Entsprechend eines gewünschten Informationsinhaltes der zu übertragenden Signale erfolgt eine Modulation der Sendeleistung der Laserdioden. Die Anregung der Laserdioden erfolgt über die Einstellung eines, über die Laserdiode fließenden Pumpstromes. Durch eine Hochfrequenzmodulation des Pumpstromes können die zu übertragenden Informationen in Bit-Folgen umgesetzt werden, die eine entsprechende Pulsierung der von der Laserdiode generierten optischen Signale bewirken.

Um die Modulation des Pumpstromes zu erzielen, ist bekannt, Laserdioden mit einem sogenannten Laservorstrom vorzuspannen, mittels dem die Laserdiode bis zu einem Schwellstrom angeregt wird. Mittels des frequenzmodulierten Modulationsstromes, der dem Laservorstrom aufaddiert wird, wird dann der Pumpstrom moduliert, wobei entsprechend der Frequenzfolge des Modulationsstromes die Ausgangsleistung der Laserdiode moduliert wird, indem der Pumpstrom informationsabhängig über den Schwellstrom angehoben wird.

Beim Einsatz von Laserdioden in optischen Übertragungssystemen ist eine Begrenzung der Ausgangsleistung der Laserdioden erforderlich. Bekannt ist, eine Lasersicherheitsabschaltung zu integrieren, die im Fehlerfalle eine Abschaltung der Laserdiode übernimmt. Diese ist jedoch nur sehr aufwendig und somit kostenintensiv zu realisieren.

Bekannt ist ein Verfahren zur Regelung der Ausgangsleistung einer Laserdiode, um die Ausgangsleistung auf einen Maximalwert zu begrenzen. Hierbei wird die Sendeleistung der Laserdiode mittels einer Monitordiode (Photodiode) optisch erfaßt und ein hieraus resultierender Monitorstrom zur Einregelung des Vorstromes der Laserdiode eingesetzt. Somit ist eine unmittelbare Regelung des Vorstromes und somit der Sendeleistung des Lasers auf einen vorbestimmten Wert möglich. Bei dieser Schaltungsanordnung ist jedoch nachteilig, daß im Falle eines Fehlers, beispielsweise durch einen Kurzschluß in der Vorstromschaltung oder einer Unterbrechung des Vorstromregelkreises, ständig ein maximaler Vorstrom fließt. Da die Ausgangsleistung einer Laserdiode bekanntermaßen temperaturabhängig ist, muß ein maximaler Vorstrom so eingestellt sein, daß bei allen möglichen auftretenden Temperaturen eine gewünschte Ausgangsleistung (Sendeleistung) der Laserdiode erreichbar ist. Mit sinkender Umgebungstemperatur an der Laserdiode ist ein geringerer Vorstrom zur Erreichung der gewünschten Ausgangsleistung notwendig. Tritt nunmehr bei den bekannten Schaltungsanordnungen zur Regelung der Ausgangsleistung einer Laserdiode der genannte Fehlerfall ein, kann bei einer niederen Umgebungstemperatur und gleichzeitig maximalem Vorstrom ein Überschreiten der maximal zulässigen Ausgangsleistung der Laserdiode nicht verhindert werden.

### Vorteile der Erfindung

Die erfindungsgemäße Schaltungsanordnung mit den im Anspruch 1 genannten Merkmalen bieten demgegenüber den Vorteil, daß ein Überschreiten der maximalen Ausgangsleistung der Laserdiode mit großer Sicherheit vermieden wird. Dadurch, daß die Vorstromschaltung zwei unabhängig voneinander einstellbare Teil-Vorströme bereitstellt, die zu dem Vorstrom der Laserdiode addiert werden, ist vorteilhaft möglich, die Laserdiode nahe an der vorgegebenen maximalen Ausgangsleistung zu betreiben, wobei durch die Aufteilung in die unabhängig voneinander einstellbaren Teil-Vorströme eine Redundanz erzielbar ist, die im Fehlerfalle ein Ansteigen des Vorstromes auf einen Wert verhindert, der zu einer unzulässig hohen Ausgangsleistung führen würde. Durch die getrennte Ausbildung von Vorstromschaltung und Modulationsschaltung ist eine unabhängige Einstellung des Vorstroms sowie des Modulationsstroms möglich, so dass die erfindungsgemäße Schaltungsanordung sehr flexibel ausgebildet ist.

In bevorzugter Ausgestaltung der Erfindung ist vorgesehen, daß ein erster Teil-Vorstrom eine Leistungsregelung der Laserdiode übernimmt und ein zweiter Teil-Vorstrom einen temperaturabhängigen Stromanteil liefert. Hierdurch wird es möglich, nichttemperaturstabilisierte Laserdioden einzusetzen und trotzdem in jedem Betriebsfalle, auch im Fehlerfalle, die Überschreitung einer maximal zulässigen Ausgangsleistung einzuhalten. Insbesondere, da der erste Teil-Vorstrom den temperaturabhängigen Vorstrom nicht abdecken muß, kann dieser vorteilhaft zum Ausgleich von chargenbedingten und/oder alterungsbedingten Schwankungen der Ausgangsleistungen der Laserdiode eingesetzt werden. Durch Zuordnung von Vorwiderständen zu den zwei unabhängig voneinander wirkenden Vorstromschaltungen kann ein maximaler Vorstrom und somit eine maximale Ausgangsleistung der Laserdiode eingestellt werden. Dieser wird so gewählt, daß auch im Fehlerfalle in einem der Vorstromregelkreise und gleichzeitig minimal anzunehmender Umgebungstemperatur der Laserdiode der Vorstrom keine Werte annimmt, die zu einem Überschreiten der maximalen Ausgangsleistung der Laserdiode führt.

Insgesamt wird mit einfachen Schaltungsbestandteilen erreicht, daß nichttemperaturstabilisierte Laserdioden eingesetzt werden können, und auf eine Lasersicherheitsabschaltung verzichtet werden kann.

Vorteilhafte Ausgestaltungen der Erfindung ergeben sich aus den in den Unteransprüchen genannten Merkmalen.

### Zeichnung

Die Erfindung wird nachfolgend in einem Ausführungsbeispiel anhand der zugehörigen Zeichnung, die eine Schaltungsanordnung zur Regelung der Ausgangsleistung einer Laserdiode zeigt, näher erläutert.

### Beschreibung des Ausführungsbeispiels

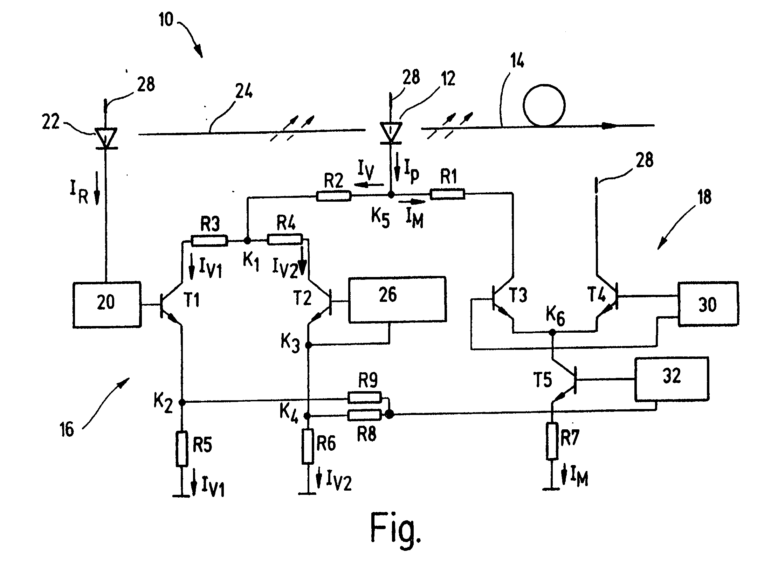

Die Figur zeigt eine Schaltungsanordnung 10 zur Ansteuerung einer Laserdiode 12. Die Laserdiode 12 ist mit ihrer lichtemittierenden Fläche einer optischen Übertragungsstrecke 14, beispielsweise einem Lichtwellenleiter, zugeordnet. Zur Ansteuerung der Laserdiode 12 ist eine Vorstromschaltung 16 sowie eine Modulationsschaltung 18 vorgesehen. Die Vorstromschaltung 16 umfaßt einen Transistor T₁, dessen Kollektor über einen Widerstand R₃ mit einem Knotenpunkt K₁ verbunden ist. Der Emitter des Transistors T₁ ist über einen Knotenpunkt K₂ sowie einem Widerstand R₅ mit Masse verbunden. Die Basis des Transistors T₁ ist über eine Vorstromregelung 20 ansteuerbar. Die Vorstromregelung 20 erhält ein Regelsignal von einer Monitordiode (Photodiode) 22, deren lichtempfindliche Fläche einer optischen Übertragungsstrecke 24 zugeordnet ist, deren anderes Ende einer lichtemittierenden Fläche der Laserdiode 12 zugeordnet ist.

Die Vorstromschaltung 16 umfaßt ferner einen Transistor T₂, dessen Kollektor über einen Widerstand R₄ mit dem Knotenpunkt K₁ verbunden ist. Ein Emitter des Transistors T₂ ist über einen Knotenpunkt K₃ sowie einen Knotenpunkt K₄ und einen Widerstand R₆ mit Masse verbunden. Die Basis des Transistors T₂ ist mit einer Temperaturregelung 26 verbunden, die ein Regelsignal über den Knotenpunkt K₃ erhält. Der Knotenpunkt K₁ ist über einen Widerstand R₂ mit einem Knotenpunkt K₅ verbunden.

Die Modulationsschaltung 18 umfaßt eine Differenzverstärkerschaltung von Transistoren T₃ und T₄. Der Kollektor des Transistors T₃ ist über einen Widerstand R₁ mit einem Knotenpunkt K₅ verbunden. Der Emitter des Transistors T₃ ist über einen Knotenpunkt K₆ mit dem Emitter des Transistors T₄ verbunden, dessen Kollektor mit einem auf Bezugspotential liegenden Anschluß 28 verbunden ist. Die Basen der Transistoren T₃ und T₄ sind jeweils mit einer Signalsteuerung 30 verbunden. Der Knotenpunkt K₆ ist mit einem Kollektor eines Transistors T₅ verbunden, dessen Emitter über einen Widerstand R₇ mit Masse verbunden ist. Die Basis des Transistors T₅ ist mit einer Steuerung 32 verbunden, deren Steuereingang über Widerstände R₈ beziehungsweise R₉ mit den Knotenpunkten K₂ beziehungsweise K₄ der Vorstromschaltung 16 verbunden ist.

### Die Schaltungsanordnung 10 zeigt folgende Funktion:

Über die Vorstromschaltung 16 wird ein Vorstrom I_{V} geregelt, der Teil eines Pumpstromes I_{P} der Laserdiode 12 ist. Die Größe des Vorstromes I_{V} wird einerseits über die Vorstromregelung 20 und andererseits über die Temperaturregelung 26 bestimmt. Die Vorstromregelung 20 bestimmt die Größe des Vorstromes I_{V1}, während die Temperaturregelung 26 die Größe des Vorstromes I_{V2} bestimmt, die im Knotenpunkt K₁ zum Vorstrom I_{V} addiert werden.

Über die Monitordiode 22 wird die von der Laserdiode 12 abgegebene optische Leistung erfaßt. Hierzu emittiert die Laserdiode 12 ihre optischen Signale in die Referenzübertragungsstrecke 24, wobei die Monitordiode 22 diese optischen Signale empfängt und in elektrische Signale wandelt. Dieser Monitorstrom I_{R} stellt eine Regelgröße für die Vorstromregelung 20 dar, die die Basis des Transistors T₁ ansteuert. Je nach Größe des Monitorstromes I_{R} erfolgt eine Durchsteuerung des Transistors T₁. Somit wird über den Monitorstrom I_{R} die Größe des Teil-Vorstromes I_{V1} bestimmt. Die Widerstände R₂, R₃ und R₅, über die der Teil-Vorstrom I_{V1} fließt, dienen als Strombegrenzungswiderstände, so daß der Teil-Vorstrom I_{V1} auf einen Maximalwert begrenzbar ist. Dieser Maximalwert ist so gewählt, daß ein Pumpstrom I_{P} der Laserdiode 12, der sich aus der Summe des Vorstromes I_{V} und eines Modulationsstromes I_{M} ergibt, wobei sich der Vorstrom I_{V} aus der Summe der Teil-Vorströme I_{V1} und I_{V2} ergibt, einen derartigen Maximalwert annehmen kann, bei dem eine Ausgangsleistung (Sendeleistung) der Laserdiode 12 einen vorgebbaren Maximalwert nicht überschreitet. Beim Einsatz in optischen Übertragungssystemen ist eine Leistungsbegrenzung in eine sogenannte Laserklasse 1 üblich, das heißt, bei einer Wellenlänge der optischen Signale von λ = 1300 nm beträgt eine Ausgangsleistung Pₒᵤₜ der Laserdiode 12 maximal 9 mW, und bei einer Wellenlänge λ = 1550 nm beträgt die Ausgangsleistung Pₒᵤₜ maximal 10 mW.

Der Teil-Vorstrom I_{V2}, der in den Vorstrom I_{V} und somit in den Pumpstrom I_{P} einfließt, wird über die Temperaturregelung 26 eingestellt. Die Temperaturregelung 26 steuert die Basis des Transistors T₂ an, wobei diese Regelung temperaturabhängig erfolgt. Der temperaturabhängige Teil-Vorstrom I_{V2} wird hierbei mit einem Anstieg eingeregelt, der kleiner oder gleich einem temperaturabhängigen Anstieg eines Schwellstromes der Laserdiode 12 ist. Dieser Schwellstrom der Laserdiode 12 bestimmt, ab welchem Pumpstrom I_{P} eine bestimmte Ausgangsleistung bereitgestellt wird. Dieser Schwellstrom schwankt bekanntermaßen mit der Temperatur. Bei niederen Temperaturen ist ein geringerer Schwellstrom notwendig, das heißt, mit einem geringeren Pumpstrom I_{P} wird die gleiche Ausgangsleistung Pₒᵤₜ erzeugt wie bei einem höheren Pumpstrom I_{P} und höherer Temperatur. Eine Dimensionierung des temperaturabhängigen Teil-Vorstromes I_{V2} ist so gewählt, daß bei einem Temperaturbereich von 0°C bis 70°C dieser etwa einen Wert von I_{V2} = 0 bis 30 mA annimmt. Die Widerstände R₄ und R₆ dienen hierbei als Strombegrenzungswiderstände, die ein Ansteigen des Teil-Vorstromes I_{V2} über einen zulässigen Höchstwert begrenzen.

Der Modulationsstrom I_{M} wird über die Modulationsschaltung 18 erzeugt, wobei dieser über die Ansteuerung der Transistoren T₃ und T₄ in Abhängigkeit der Signalsteuerung 30 getrieben wird. Der Modulationsstrom I_{M} wird hierbei über die Signalsteuerung 30 hochfrequent getrieben, so daß durch die Addition des Vorstromes I_{V} und des Modulationsstromes I_{M} im Knotenpunkt K₅ zum Pumpstrom I_{P} dieser entsprechend der Ansteuerung des Modulationsstromes I_{M} über die Signalsteuerung 30 über beziehungsweise unter den Schwellstrom der Laserdiode 12 getrieben wird. Hierdurch schwankt die Ausgangsleistung Pₒᵤₜ der Laserdiode 12 entsprechend der durch die Signalsteuerung 30 vorgegebenen Werte, so daß eine Signalübertragung in bekannter Weise möglich wird. Die Ausgangsleistung der Laserdiode 12 wird in die Übertragungsstrecke 14 eingespeist und ist von, in der Figur nicht dargestellten Empfängern abgreifbar. Die Widerstände R₁ und R₇ dienen wiederum als Strombegrenzungswiderstände, so daß ein durch die Höhe der Widerstände vorgebbarer maximaler Modulationsstrom I_{M} nicht überschritten werden kann.

Über den Transistor T₅ erfolgt eine Nachführung des Modulationsstromes I_{M}. Hierbei werden über die Modulationssteuerung 32 die Teil-Vorströme I_{V1} beziehungsweise I_{V2} über die Knotenpunkte K₂ beziehungsweise K₄ abgegriffen und entsprechend einer Änderung der Werte der Teil-Vorströme I_{V1} und/oder I_{V2} eine Nachführung Modulationsstromes I_{M} durchgeführt. Somit wird einerseits über den Abgriff des Teil-Vorstromes I_{V2} eine temperaturabhängige Nachführung des Modulationsstromes I_{M} und über den Abgriff des Teil-Vorstromes I_{V1} eine leistungsabhängige Nachführung des Modulationsstromes I_{M} möglich. Die Höhe des Modulationsstromes I_{M} wird bei der Einstellung der Schaltungsanordnung 10 auf einen konstanten Wert eingestellt, der so gewählt ist, daß durch die Addition des Modulationsstromes I_{M} mit dem Vorstrom I_{V} zu dem Pumpstrom I_{P} dieser über den Schwellstrom der Laserdiode 12 liegt. Entsprechend der Hochfrequenzansteuerung der Signalsteuerung 30 wird der Modulationsstrom I_{M} getriggert, so daß über die Anzahl und/oder Länge der Triggerung eine Signalaufmodulierung auf den Modulationsstrom I_{M} und somit auf den Pumpstrom I_{P} und über diesen auf die Ausgangsleistung Pₒᵤₜ der Laserdiode 12 erfolgt. Die Begrenzung des maximalen Modulationsstromes I_{M} über die Widerstände R₁ und R₇ ist so gewählt, daß im Normalbetrieb ein ausreichend großer Modulationsstrom I_{M} fließt, der bei Laserdioden 12 auch bei geringer Steilheit die erforderliche Ausgangsleistung erreichen läßt.

Die erfindungsgemäße Schaltungsanordnung 10 bietet den Vorteil, daß auch in einem anzunehmenden Fehlerfall, der beispielsweise infolge eines Kurzschlusses einer der Transistoren T₁, T₂, T₃ oder T₄ oder eines Ausfalles einer der Regelungen beziehungsweise Steuerungen 20, 26, 30 beziehungsweise 32 gegeben sein kann, ein maximaler Pumpstrom I_{P} nicht überschritten werden kann, der zu einem Ansteigen der Ausgangsleistung Pₒᵤₜ der Laserdiode 12 über einen vorgegebenen Maximalwert, beispielsweise einem der Laserklasse 1 entsprechenden Maximalwert, führt. Insbesondere durch die Auftrennung des Vorstromes I_{V} in die Teil-Vorströme I_{V1} und I_{V2}, und somit die Trennung des Vorstromanteiles zur Leistungsregelung der Laserdiode 12 von dem Vorstromanteil zur Temperaturregelung, ist es möglich, die beiden Stromquellen unabhängig und getrennt voneinander so zu begrenzen, daß ein Überschreiten der maximal zulässigen Ausgangsleistung Pₒᵤₜ der Laserdiode 12 verhindert wird. Beispielsweise wird bei einem Fehlerfall in dem den temperaturabhängigen Teil-Vorstrom I_{V2} bereitstellenden Schaltungsteil die Vorstromregelung 20 den Teil-Vorstrom I_{V1} entsprechend zurückführen, so daß der maximale Vorstrom I_{V} nicht überschritten wird. Über die Rückkopplung der Ausgangsleistung (Sendeleistung) der Laserdiode 12 über die Monitordiode 22 wird dieser Leistungsanstieg über den Monitorstrom I_{R} als Regelgröße bereitgestellt, so daß der Transistor T₁ entsprechend zur Begrenzung des Teil-Vorstromes I_{V1} angesteuert werden kann. Durch die Trennung der Stromquelle zur Bereitstellung des Vorstromes I_{V} in die Teilstromquellen wird eine Redundanz erreicht, die im Fehlerfall des einen Stromzweiges beziehungsweise anderen Stromzweiges jeweils eine maximale Begrenzung des Vorstromes I_{V} und somit des Pumpstromes I_{P} gewährleistet. Erst im nicht anzunehmenden Fall des gleichzeitigen Kurzschlusses in den Transistoren T₁ und T₂ kann ein Anstieg des Pumpstromes I_{P} über einen maximal zulässigen Wert möglich werden.

Durch das Erfassen der Ausgangsleistung Pₒᵤₜ der Laserdiode 12 über die Monitordiode 22 kann gleichzeitig eine Alterung der Laserdiode 12 sowie eine Chargenstreuung unterschiedlicher Laserdioden 12 ausgeglichen werden. Die tatsächlichen Ausgangsleistung Pₒᵤₜ der Laserdiode 12 wird zur Einregelung des Teil-Vorstromes I_{V1} und somit des Vorstromes I_{V} und somit des Pumpstromes I_{P} herangezogen.

Der temperaturabhängige Teil-Vorstrom I_{V2} ist so gewählt, daß über den gesamten möglichen Temperaturbereich dieser immer unterhalb des Schwellstromes der Laserdiode 12 liegt. Somit kann allein mit dem temperaturabhängigen Teil-Vorstrom I_{V2} keine zusätzliche Ausgangsleistung (optische Leistung) der Laserdiode 12 erreicht werden, so daß eine maximal zulässige Leistung der Laserdiode 12 nicht überschritten werden kann.

Durch die Bereitstellung der zwei unabhängig voneinander einstellbaren Teil-Vorströme I_{V1} beziehungsweise I_{V2} kann die Laserdiode 12 näher an ihrer Leistungsgrenze betrieben werden. Ein Sicherheitsabstand zur Leistungsgrenze, bei der ein Überschreiten einer maximalen zulässigen Leistung erfolgt, kann somit verringert werden, und der Wirkungsgrad der Laserdiode 12 ist verbessert. Insbesondere ein Fehlerfall bei relativ tiefen Temperaturen, bei dem ein relativ niedriger Pumpstrom I_{P} ausreicht, um die maximal zulässige Ausgangsleistung Pₒᵤₜ zu überschreiten, kann nicht zu einem Anwachsen des Pumpstromes I_{P} über einen maximal zulässigen Wert führen, der das Überschreiten der maximal zulässigen Ausgangsleistung Pₒᵤₜ bewirken würde. Ferner ist vorteilhaft, daß durch die Trennung in die Leistungsregelung des Vorstromes I_{V} und die Temperaturregelung des Vorstromes I_{V} die leistungsabhängige Regelung einen größeren möglichen Steuerbereich zum Ausgleich von Alterungserscheinungen beziehungsweise einer Leistungsstreuung bei unterschiedlichen Chargen von Laserdioden 12 auweist.

## Patentansprüche

1. Schaltungsanordnung zur Regelung der Ausgangsleistung einer Laserdiode (12), mit einer Vorstromschaltung (16), die zur Erzeugung einer unterhalb eines Schwellstromes der Laserdiode liegenden Pumpstromes (I_{P}) ausgebildet ist, und einer Modulationsschaltung (18), die zur signalabhängigen Anhebung des Pumpstromes (I_{P}) der Laserdiode (12) über den Schwellstrom ausgebildet ist, wodurch eine optische Signalfolge der Laserdiode (12) erzeugt wird, wobei die Vorstromschaltung (16) zwei separate Teil-Vorstromschaltungen umfasst und durch diese zwei unabhängig voneinander einstellbare Teil-Vorströme (I_{V1}, I_{V2}) bereitstellt, die zu dem Vorstrom (I_{V}) der Laserdiode (12) addiert werden,
**dadurch gekennzeichnet,**
**dass** die Vorstromschaltung (16) getrennt von der Modulationsschaltung (18) ausgebildet ist.

2. Schaltungsanordnung nach Anspruch 1, **dadurch gekennzeichnet, daß** ein erster Teil-Vorstrom (I_{V1}) zur Leistungsregelung der Laserdiode (12) einregelbar ist.

3. Schaltungsanordnung nach einem der vorhergehenden Ansprüche, **dadurch gekennzeichnet, daß** ein zweiter Teil-Vorstrom (I_{V2}) zur temperaturabhängigen Einstellung des Vorstromes (I_{V}) einregelbar ist.

4. Schaltungsanordnung nach einem der vorhergehenden Ansprüche, **dadurch gekennzeichnet, daß** die Vorstromschaltung (16) einen Transistor (T₁) aufweist, der den leistungsabhängigen Teil-Vorstrom (I_{V1}) treibt, dessen Kollektor über Widerstände (R₃, R₂) mit der Laserdiode (12), dessen Emitter über einen Widerstand (R₅) mit Masse verbunden ist und dessen Basis mit einem von der Laserdiode (12) ausgangsleistungsabhängigen Regelsignal beaufschlagbar ist.

5. Schaltungsanordnung nach einem der vorhergehenden Ansprüche, **dadurch gekennzeichnet, daß** die Vorstromschaltung (16) einen Transistor (T₂) aufweist, der den temperaturabhängigen Teil-Vorstrom (I_{V2}) treibt, dessen Kollektor über einen Widerstand (R₄) und den Widerstand (R₂) mit der Laserdiode (12), dessen Emitter über einen Widerstand (R₆) mit Masse verbunden ist, und dessen Basis mit einem temperaturabhängigen Regelsignal beaufschlagbar ist.

6. Schaltungsanordnung nach Anspruch 4, **dadurch gekennzeichnet, daß** das Regelsignal von einer Monitordiode (22) geliefert wird, die die momentane Ausgangsleistung der Laserdiode (12) überwacht.

7. Schaltungsanordnung nach Anspruch 5, **dadurch gekennzeichnet, daß** der temperaturabhängige Teil-Vorstrom (I_{V2}) mit einem Anstieg eingeregelt wird, der kleiner oder gleich einem temperaturabhängigen Anstieg des Schwellstromes der Laserdiode (12) ist.

8. Schaltungsanordnung nach einem der vorhergehenden Ansprüche, **dadurch gekennzeichnet, daß** der temperaturabhängige Teil-Vorstrom (I_{V2}) einen Maximalwert annehmen kann, der unterhalb des Schwellstromes der Laserdiode (12) liegt.

9. Schaltungsanordnung nach einem der vorhergehenden Ansprüche, **dadurch gekennzeichnet, daß** die Modulationsschaltung (18) eine Nachführanordnung für den Modulationsstrom (I_{M}) umfaßt, die in Abhängigkeit einer Größe des ersten Teil-Vorstromes (I_{V1}) und/oder des zweiten Teil-Vorstromes (I_{V2}) den Modulationsstrom (IM) nachführt.

10. Schaltungsanordnung nach einem der vorhergehenden Ansprüche, **dadurch gekennzeichnet, daß** die Schaltungsanordnung (10) zur Regelung der Ausgangsleistung einer Laserdiode (12) in einem optischen Übertragungsnetz verwendet wird.

## Claims

1. A circuit arrangement for regulating the output power of a laser diode (12) comprising a forward current circuit (16) adapted to generate a pump current (I_{P}) below a threshold current of the laser diode and a modulation circuit (18) adapted to increase the pump current (I_{P}) of the laser diode (12) above the threshold current in dependence on a signal, whereby an optical signal sequence of the laser diode (12) is generated, with the forward current circuit (16) including two separate part forward current circuits and providing by these two part forward currents (I_{V1}, I_{V2}) which can be adjusted independently from one another and which are added to form the forward current (I_{V}) of the laser diode (12),
**characterised in that**
the forward current circuit (16) is separate from the modulation circuit (18).

2. A circuit arrangement in accordance with claim 1, **characterised in that** a first part forward current (I_{V1}) can be adjusted for the power regulation of the laser diode (12).

3. A circuit arrangement in accordance with any one of the preceding claims, **characterised in that** a second part forward current (I_{V2}) can be adjusted for the temperature-dependent setting of the forward
current (Iv).

4. A circuit arrangement in accordance with any one of the preceding claims, **characterised in that** the forward current circuit (16) has a transistor (T₁) which drives the power-dependent part forward current (I_{V1}) whose collector is connected via resistors (R₃, R₂) to the laser diode (12) whose emitter is connected to earth via a resistor (R₅) and whose base can be acted on by a regulating signal dependent on the output power of the laser diode (12).

5. A circuit arrangement in accordance with any one of the preceding claims, **characterised in that** the forward current circuit (16) has a transistor (T₂) which drives the temperature-dependent part forward current (I_{V2}) whose collector is connected via a resistor (R₄) and via the resistor (R₂) to the laser diode (12) whose emitter is connected to earth via a resistor (R₆) and whose base can be acted on by a temperature-dependent regulating signal.

6. A circuit arrangement in accordance with claim 4, **characterised in that** the regulating signal is delivered by a monitor diode (22) which monitors the instantaneous output power of the laser diode (12).

7. A circuit arrangement in accordance with claim 5, **characterised in that** the temperature-dependent part forward current (I_{V2}) is set with an increase which is lower than or equal to a temperature-dependent increase in the threshold current of the laser diode (12).

8. A circuit arrangement in accordance with any one of the preceding claims, **characterised in that** the temperature-dependent part forward current (I_{V2}) can adopt a maximum value which lies below the threshold current of the laser diode (12).

9. A circuit arrangement in accordance with any one of the preceding claims, **characterised in that** the modulation circuit (18) comprises a tracking arrangement for the modulation current (I_{M}) which tracks the modulation current (I_{M}) in dependence on a value of the first part forward current (I_{V1}) and/or of the second part forward current (I_{V2}).

10. A circuit arrangement in accordance with any one of the preceding claims, **characterised in that** the circuit arrangement (10) is used for the regulation of the output power of a laser diode (12) in an optical transmission network.

## Revendications

1. Agencement de circuit pour la régulation de la puissance de sortie d'une diode laser (12), comportant un circuit de pré-courant (16) qui est réalisé pour générer un courant de pompage (I_{P}) situé au-dessous d'un courant seuil de la diode laser, et un circuit de modulation (18) qui est réalisé pour l'augmentation du courant de pompage (I_{P}) de la diode laser (12) au-dessus du courant seuil, en fonction du signal, ce qui génère une succession de signaux optiques de la diode laser (12), le circuit de pré-courant (16) comprenant deux circuits de pré-courant partiels séparés et fournissant par ceux-ci deux pré-courants partiels (I_{V1}, I_{V2}) réglables indépendamment l'un de l'autre, qui sont additionnés au pré-courant (I_{V}) de la diode laser (12),
**caractérisé en ce que**
le circuit de pré-courant (16) est réalisé séparément du circuit de modulation (18).

2. Agencement de circuit selon la revendication 1, **caractérisé en ce qu'**un premier pré-courant partiel (I_{V1}) est ajustable pour la régulation de la puissance de la diode laser (12).

3. Agencement de circuit selon l'une des revendications précédentes, **caractérisé en ce qu'**un second pré-courant partiel (I_{V2}) est ajustable pour le réglage du pré-courant (I_{V}) en fonction de la température.

4. Agencement de circuit selon l'une des revendications précédentes, **caractérisé en ce que** le circuit de pré-courant (16) comprend un transistor (T₁) qui pilote le pré-courant partiel (I_{V1}) dépendant de la puissance, dont le collecteur est connecté à la diode laser (12) via des résistances (R₃, R₂), dont l'émetteur est connecté à la masse via une résistance (R₅) et dont la base est susceptible d'être sollicitée par un signal de régulation dépendant de la puissance de sortie de la diode laser (12).

5. Agencement de circuit selon l'une des revendications précédentes, **caractérisé en ce que** le circuit de pré-courant (16) comprend un transistor (T₂) qui pilote le pré-courant partiel (I_{V2}) dépendant de la température, dont le collecteur est connecté à la diode laser (12) via une résistance (R₄) et via la résistance (R₂), dont l'émetteur est connecté à la masse via une résistance (R₆) et dont la base est susceptible d'être sollicitée par un signal de régulation dépendant de la température.

6. Agencement de circuit selon la revendication 4, **caractérisé en ce que** le signal de régulation est fourni par une diode de contrôle (22) qui surveille la puissance de sortie momentanée de la diode laser (12).

7. Agencement de circuit selon la revendication 5, **caractérisé en ce que** le pré-courant partiel (I_{V2}) dépendant de la température est ajusté avec une croissance qui est inférieure ou égale à une croissance, dépendante de la température, du courant seuil de la diode laser (12).

8. Agencement de circuit selon l'une des revendications précédentes, **caractérisé en ce que** le pré-courant partiel (I_{V2}) dépendant de la température peut prendre une valeur maximale qui est inférieure au courant seuil de la diode laser (12).

9. Agencement de circuit selon l'une des revendications précédentes, **caractérisé en ce que** le circuit de modulation (18) comprend un organe suiveur pour le courant de modulation (I_{M}), qui fait suivre le courant de modulation (I_{M}) en fonction d'une intensité du premier pré-courant partiel (I_{V1}) et/ou du second pré-courant partiel (I_{V2}).

10. Agencement de circuit selon l'une des revendications précédentes, **caractérisé en ce que** l'agencement de circuit (10) est utilisé pour la régulation de la puissance de sortie d'une diode laser (12) dans un réseau de transmission optique.
